# EUROPÄISCHE PATENTANMELDUNG

(11) **EP 2 020 751 A2**
(43) Veröffentlichungstag der Anmeldung: **04.02.2009**
(21) Anmeldenummer: 08012362.3
(22) Anmeldetag: 09.07.2008
(51) Int. Cl.: H03K 17/691, H03K 17/567

(54) **Treiberschaltung für einen Stromrichter mit Zwischenkreis**

(30) Priorität: 03.08.2007 DE 102007036700
(71) Anmelder: SEMIKRON Elektronik GmbH & Co. KG, 90431 Nürnberg (DE)
(72) Erfinder: Bode, Rüdiger, 90763 Fürth (DE); Katzenberger, Günter, 97084 Würzburg (DE); Hofmair, Markus, 91154 Roth (DE); Obernöder, Daniel, 97346 Iphofen (DE)

(57) **Zusammenfassung**

Eine Treiberschaltung (6) für einen Stromrichter (2) mit Zwischenkreis (4) enthält
- eine Primärseite (10a) und eine Sekundärseite (10b), wobei die Sekundärseite (10b) eine Messeinrichtung (16) zur Ausgabe eines mit einer Zwischenkreisspannung (U_{z}) korrelierten ersten Analogsignals (24a) und einen A/D-Wandler (30) zur Umwandlung des ersten Analogsignals (24a) in einen Digitalwert (32) enthält,
- ein galvanisch trennendes Übertragungselement (36) zur Übertragung des Digitalwertes (32) von der Sekundär- (10b) zur Primärseite (10a).

## Beschreibung

Die Erfindung betrifft eine Treiberschaltung für einen Stromrichter, welcher einen Zwischenkreis aufweist.

Stromrichter sind Baugruppen der Leistungselektronik, welche Halbleiterschalter enthalten und mit diesen in der Regel hohe Ströme und Spannungen schalten. Zur Ansteuerung der Halbleiterschalter enthalten die Stromrichter Treiberschaltungen. Weiterhin weisen derartige Stromrichter einen Zwischenkreis auf, d.h. einen Schaltungsteil, welcher Gleichspannung führt. Oft ist es wünschenswert, die Größe der Zwischenkreisspannung, also der Gleichspannung im Zwischenkreis zu erfassen.

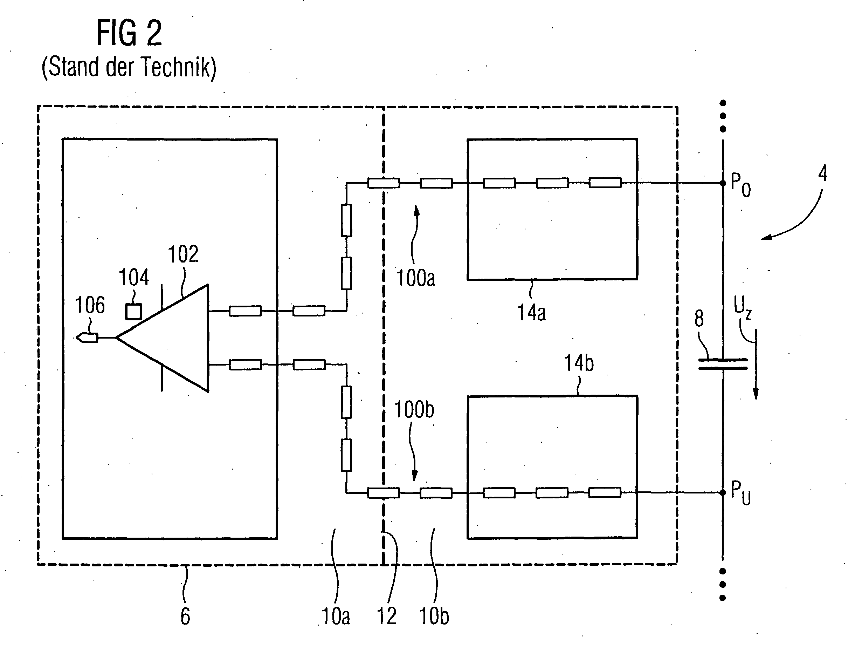

Derartige Treiberschaltungen weisen eine z.B. auf Hochspannungspotential liegende Sekundärseite und eine von dieser getrennte Primärseite mit dem Potential der Ansteuerlogik des Treibers auf. Bei Stromrichtern weist die Sekundärseite in der Regel eine sogenannten BOT- und TOP-Schaltung auf, welche jeweils getrennt für sich einen auf hohem (positiven) und niedrigem (negativen) Zwischenkreispotential liegenden Halbleiterschalter ansteuern. Es ist bekannt, die Messung der Zwischenkreisspannung auf der Primärseite durchzuführen. Um eine sichere elektrische Trennung zur Sekundärseite zu gewährleisten, erfolgt gemäß dem Stand der Technik die Verbindung zur Sekundärseite, auf welcher die Zwischenkreisspannung anliegt, über eine hochohmige Widerstandskette. Die gesamte Spannungsmessschaltung ist damit als hochohmiger Differenzverstärker aufgebaut; der eigentliche Differenzverstärker befindet sich auf der Primärseite. Fig. 2 zeigt einen derartigen bekannten Treiber 6 mit Primärseite 10a und Sekundärseite 10b, wobei die Sekundärseite 10b eine TOP-Baugruppe 14a und eine BOT-Baugruppe 14b aufweist. Von einem Zwischenkreis 4 ist nur der Zwischenkreiskondensator 8 dargestellt, an welchem die zu messenden Zwischenkreisspannung U_{Z} abfällt. Zur Spannungsmessung sind die Potentiale P_{O} und P_{U} zwischen welchen die Spannung U_{Z} anliegt, über je eine Widerstandskette 100a,b von den Potentialen P_{O} und P_{U} durch die Sekundärseite 10b in die Primärseite 10a und dort auf einen Differenzverstärker 102 geführt. Die galvanische Trennung zwischen Primärseite 10a und Sekundärseite 10b, angedeutet durch die Linie 12 ist damit keine echte galvanische Trennung, da sie von den jeweiligen Widerstandsketten 100a,b überbrückt ist. Im primärseitigen Differenzverstärker 102 wird die Spannung U_{Z} in ein der Spannung U_{Z} proportionales bzw. mit dieser korreliertes Analogsignal 104 umgewandelt, welches an einem Ausgang 106 des Differenzverstärkers 102 zur weiteren Verarbeitung bereitgestellt wird.

Durch die Widerstandskette besteht eine direkte Verbindung zur Sekundärseite, d.h. Primärseite und Sekundärseite weisen keine echte galvanische Trennung auf. Die Messung der Zwischenkreisspannung ist ungenau, da aus Gründen der elektrischen Trennung zwischen Primär- und Sekundärseite sehr hohe Eingangswiderstände in Form der Widerstandsketten verwendet werden müssen und dennoch keine galvanische Trennung vorliegt. Eine derartige Treiberschaltung ist außerdem bauteil- und platzintensiv, da viele Widerstände benötigt werden und im Umgebungsbereich der Widerstandskette Sicherheitsabstände wegen der hohen anliegenden Spannungen eingehalten werden müssen.

Aufgabe der vorliegenden Erfindung ist es, in einer Treiberschaltung für einen Stromrichter mit Zwischenkreis eine verbesserte Erfassung der Zwischenkreisspannung zu realisieren.

Die Aufgabe wird gelöst durch eine Treiberschaltung für einen Stromrichter, welcher einen Zwischenkreis aufweist. Im Zwischenkreis liegt eine im Betrieb der Treiberschaltung zu messende Zwischenkreisspannung an. Die Treiberschaltung weist eine Primärseite und eine Sekundärseite auf. Die Sekundärseite enthält eine Messeinrichtung zur Ausgabe eines mit der Zwischenkreisspannung korrelierten ersten Analogsignals. Die Sekundärseite enthält außerdem einen A/D-Wandler zur Umwandlung des ersten Analogsignals in eine Digitalwert. Der Digitalwert repräsentiert damit ebenfalls die gemessene Zwischenkreisspannung. Die Treiberschaltung enthält außerdem ein galvanisch trennendes Übertragungselement, das zur Übertragung des Digitalwertes von der Sekundär- zur Primärseite dient.

Im erfindungsgemäßen Treiber erfolgt die eigentliche Spannungsmessung durch die Messeinrichtung auf der Sekundärseite des Treibers. Durch den A/D-Wandler erfolgt eine auf Sekundärseite sicher und zuverlässig durchführbare Umwandlung des gemessenen ersten Analogsignals in einen Digitalwert. Die Übertragung des Digitalwertes als Bitmuster über einen Signalübertrager, also das Übertragungselement in Form einer galvanisch getrennten Datenübertragung, ist störungssicher, alterungssicher und entsprechend einfach und kostengünstig durchführbar. Galvanisch sicher trennende digitale Übertragungselemente stehen in geeigneter Spannungsfestigkeit zur Verfügung.

Hierdurch steht der mit der Zwischenkreisspannung korrelierte Digitalwert auf der Primärseite exakt zur Verfügung und kann dort in beliebiger Weise weiterverarbeitet werden. Die Treiberschaltung verfügt über eine echte, vollständige galvanische Trennung.

Heutige bekannte Treiberschaltungen sind in zunehmender Weise bereits mit digitalen Teilschaltungen aufgebaut. In neuen Treibergenerationen werden z.B. Bitmuster und keine diskreten Einschaltpulse mehr übertragen. Hierzu sind bereits sekundärseitig als auch primärseitige digitale Microcontroller zur Funktions- bzw. Systemüberwachung vorhanden. Derartige Microcontroller enthalten oft ohnehin zusätzliche, in der derzeitigen Treiberausgestaltung ungenutzte A/D-Wandler bzw. Rechenressourcen etc..

Die Messeinrichtung und/oder der A/D-Wandler können daher in einem der Sekundärseite des Treibers eigenen, d.h. bereits auch ohne Implementierung des erfindungemäßen Zwischenkreisspannungsmessprinzips verwendeten, Controller angeordnet sein. Für eine erfindungsgemäße Treiberschaltung ist daher praktisch kein Mehraufwand an Bauteilen notwendig, da Messeinrichtung und/oder A/D-Wandler ohnehin in derartigen Treiberschaltungen bisher ungenutzt zur Verfügung stehen.

Auch das Übertragungselement steht in einem derartigen digitalen Treiber bereits zur Verfügung, da über dieses bzw. über die durch dieses gebildete Datenstrecke, bereits eine Fehler- bzw. Zustandsrückmeldung von der Sekundär- zur Primärseite erfolgt.

Die Primärseite kann einen D/A-Wandler zur Umwandlung des Digitalwertes in ein zweites Analogsignal enthalten. Zur weiteren Verarbeitung steht dann auf der Primärseite in gewohnter Weise ein mit der Zwischenkreisspannung exakt korreliertes Analogsignal zur Verfügung.

Die Messeinrichtung kann ein an die Zwischenkreisspannung angeschlossener Differenzverstärker sein.

Wie oben erwähnt, kann die Treiberschaltung zur Ansteuerung von zwei, in Reihe an der Zwischenkreisspannung angeschlossenen Leistungshalbleiterschaltern ausgeführt sein. Die Sekundärseite weist dann zwei Baugruppen, nämlich eine TOP- und eine BOT-Baugruppe auf, wobei jede dieser Baugruppen je einen Leistungshalbleiterschalter ansteuert. Die Messeinrichtung, also beispielsweise der Differenzverstärker, kann dann bevorzugt in der BOT-Baugruppe angeordnet sein. Diese ist die auf dem niedrigeren Potential (P_{U} in Fig. 2) der Zwischenkreisspannung liegende Baugruppe. Der Aufbau der Messeinrichtung, z.B. eines Messverstärkers, ist auf dem niedrigen Potential P_{U} bzw. in der BOT-Baugruppe einfacher als bei dessen Platzierung in der TOP-Baugruppe.

In einer derartigen Treiberschaltung kann dann die Messeinrichtung über eine Widerstandskette mit der TOP-Baugruppe verbunden sein. Da die BOT-Baugruppe mit dem unteren Potential der Zwischenkreisspannung verbunden ist, existiert so über die Widerstandskette eine hochohmige Verbindung zum hohen Potential der Zwischenkreisspannung.

Dennoch ist es auch umgekehrt zu oben möglich, die Messeinrichtung in der TOP-Baugruppe anzuordnen, falls dies z.B. wegen Bauraum- oder Designvorteilen gewünscht ist. Eine entsprechende Verbindung über eine Widerstandskette zur BOT-Baugruppe kann dann ebenfalls realisiert werden.

Für eine weitere Beschreibung der Erfindung wird auf die Ausführungsbeispiele der Zeichnungen verwiesen. Es zeigen, jeweils in einer schematischen Prinzipskizze:
Fig. 1 einen erfindungsgemäßen Treiber für einen Stromrichter mit digitaler Zwischenkreisspannungserfassung,
Fig. 2 eine Zwischenkreisspannungsmessung mit Widerstandsketten gemäß Stand der Technik.

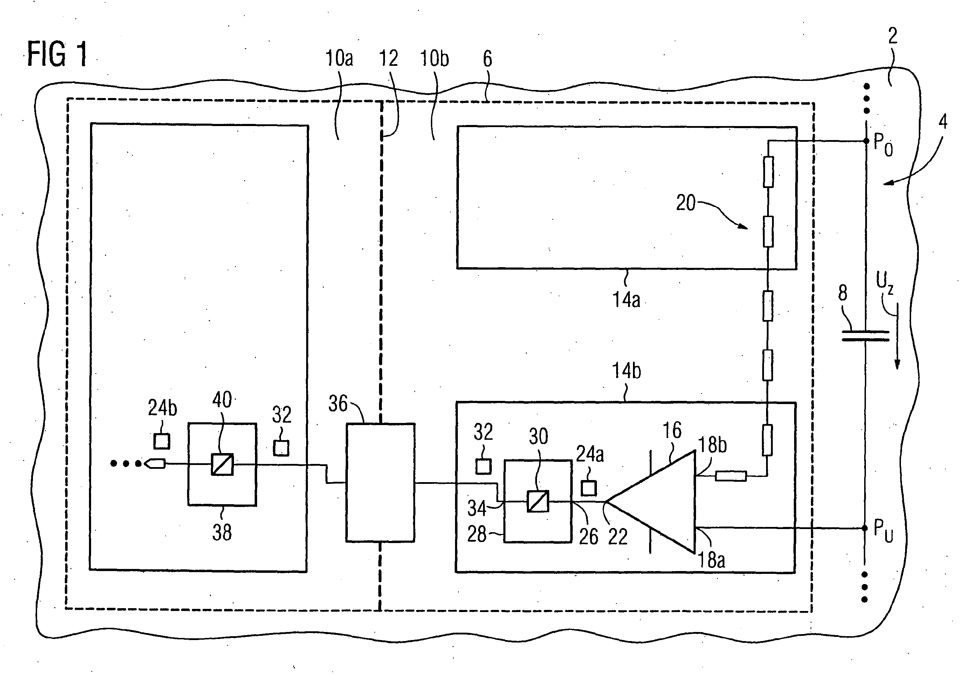

Fig. 1 zeigt einen Ausschnitt aus einem Stromrichter 2, welcher einen Zwischenkreis 4 und einen Treiber 6 enthält. Vom Zwischenkreis 4 ist nur der Zwischenkreiskondensator 8 dargestellt, an welchem im Betrieb des Stromrichters 2 die Zwischenkreisspannung U_{Z} als Gleichspannung anliegt.

Der Treiber 6 weist eine Primärseite 10a und eine Sekundärseite 10b auf, welche galvanisch voneinander getrennt sind, angedeutet durch die gestrichelte Linie 12. Die Sekundärseite 10b umfasst eine TOP-Baugruppe 14a und eine BOT-Baugruppe 14b. Die TOP-Baugruppe 14a steuert hierbei einen nicht dargestellten Leistungshalbleiterschalter an, welcher auf dem oberen Potential P_{O} des Zwischenkreises 4 liegt. Die BOT-Baugruppe 14b steuert einen zweiten entsprechenden Halbleiterschalter an, welcher auf dem unteren Potential P_{U} des Zwischenkreises 4 liegt. Zwischen den Potentialen P_{O} und P_{U} herrscht die Zwischenkreisspannung U_{Z}.

Die BOT-Baugruppe 14b enthält einen Differenzverstärker 16, dessen Messeingänge 18a,b mit den Potentialen P_{O} und P_{U} verbunden sind. Der Messeingang 18a ist hierbei direkt durchverbunden. Zwischen dem Messeingang 18b und dem Potential P_{O} bzw. der TOP-Baugruppe 14b liegt eine Widerstandskette 20. Der Differenzverstärker 16 liefert an seinem Ausgang 22 ein Analogsignal 24, das z.B. proportional dem augenblicklichen Wert der Zwischenkreisspannung entspricht.

Der Ausgang 22 ist mit einem Eingang 26 eines Controllers 28 verbunden, welcher im Treiber 6 verschiedene, nicht näher erläuterte Aufgaben erfüllt, z.B. die Ansteuerung der nicht dargestellten Halbleiterschalter und die Kommunikation mit der Primärseite 10a. Im Controller 28 ist ein A/D-Wandler 30 integriert, welcher mit dem Eingang 26 verbunden ist, das Analogsignal 24 in einen Digitalwert 32 umsetzt und diesen am Ausgang 34 des Controllers 28 zur Verfügung stellt. Der Digitalwert 32 ist hierbei beispielsweise der digitale Wert der Spannung U_{Z} in Volt.

Primärseite 10a und Sekundärseite 10b sind zur digitalen Kommunikation mit einem galvanisch trennenden Signalübertrager 36 verbunden. Hierzu ist der Signalübertrager 36 mit dem Controller 28 und mit einem Controller 38 verbunden, welcher sich auf der Primärseite 10a befindet. Auch der Controller 38 übernimmt mehrere, nicht näher erläuterte Aufgaben im Treiber 6, z.B. die Bereitstellung der an die Sekundärseite 10b zu übermittelten Schaltbefehle für die nicht dargestellten Halbleiterschalter.

Im Controller 38 ist ein D/A-Wandler 40 integriert, welcher den vom Signalübertrager 36 übertragenen Digitalwert 32 in ein Analogsignal 24b umsetzt, welches dem Analogsignal 24a dahingehend entspricht, dass es eindeutig mit der Zwischenkreisspannung U_{Z} korreliert ist. In der Primärseite 10a kann das Analogsignal 24b somit entsprechend in gewohnter Weise, z.B. wie in Fig. 2 weiterverarbeitet werden.

Alternativ kann bereits im Controller 38 der Digitalwert 32 weiterverarbeitet werden, welcher die selbe Information über die Zwischenkreisspannung U_{Z} liefert wie die Analogsignale 24a,b.

Die Controller 28 und 38 sowie der Signalübertrager 36 können auch nur speziell zur Spannungsmessung der Zwischenkreisspannung U_{Z} vorhanden sein und sonst keinerlei Aufgaben erfüllen.

## Patentansprüche

1. Treiberschaltung (6) für einen Stromrichter (2) mit Zwischenkreis (4), mit einer Primärseite (10a) und einer Sekundärseite (10b), wobei die Sekundärseite (10b) eine Messeinrichtung (16) zur Ausgabe eines mit einer Zwischenkreisspannung (U_{Z}) korrelierten ersten Analogsignals (24a) und einen A/D-Wandler (30) zur Umwandlung des ersten Analogsignals (24a) in einen Digitalwert (32) enthält, und mit einem galvanisch trennenden Übertragungselement (36) zur Übertragung des Digitalwertes (32) von der Sekundär- (10b) zur Primärseite (10a).

2. Treiberschaltung (6) nach Anspruch 1, bei der die Messeinrichtung (16) und/oder der A/D-Wandler (30) in einem der Sekundärseite (10b) eigenen Controller (28) angeordnet sind.

3. Treiberschaltung (6) nach Anspruch 1 oder 2, bei der die Primärseite (10a) einen D/A-Wandler (40) zur Umwandlung des Digitalwertes (32) in ein zweites Analogsignal (24b) enthält.

4. Treiberschaltung (6) nach einem der vorhergehenden Ansprüche, bei der die Messeinrichtung (16) ein an die Zwischenkreisspannung (U_{Z}) angeschlossener Differenzverstärker ist.

5. Treiberschaltung (6) nach einem der vorhergehenden Ansprüche, zur Ansteuerung von zwei, in Reihe an der Zwischenkreisspannung (U_{Z}) angeschlossenen Leistungsschaltern, bei der die Sekundärseite (10b) eine jeweils einen Leistungsschalter ansteuernde Top- (14a) und BOT-Baugruppe (14b) enthält, bei der die Messeinrichtung (16) in der dem kleineren Potential (P_{U}) der Zwischenkreisspannung (U_{Z}) zugewandten BOT-Baugruppe (14b) angeordnet ist.

6. Treiberschaltung (6) nach Anspruch 5, bei der die Messeinrichtung (16) über eine Widerstandskette (20) mit der TOP-Baugruppe (14a) verbunden ist.

7. Treiberschaltung (6) nach einem der Ansprüche 1 bis 4, zur Ansteuerung von zwei, in Reihe an der Zwischenkreisspannung (U_{Z}) angeschlossenen Leistungsschaltern, bei der die Sekundärseite (10b) eine jeweils einen Leistungsschalter ansteuernde Top- (14a) und BOT-Baugruppe (14b) enthält, bei der die Messeinrichtung (16) in der dem größeren Potential (P_{O}) der Zwischenkreisspannung (U_{Z}) zugewandten TOP-Baugruppe (14a) angeordnet ist.

8. Treiberschaltung (6) nach Anspruch 7, bei der die Messeinrichtung (16) über eine Widerstandskette (20) mit der Boot-Baugruppe (14b) verbunden ist.
